# EUROPEAN PATENT APPLICATION

(11) **EP 1 819 135 A2**
(43) Date of publication of application: **15.08.2007**
(21) Application number: 06020137.3
(22) Date of filing: 26.09.2006
(51) Int. Cl.: H04M 1/02

(54) **Keypad for sliding-type portable terminal**

(30) Priority: 10.02.2006 KR 20060013256
(71) Applicant: Samsung Electronics Co., Ltd., Suwon-si, Gyeonggi-Do (KR)
(72) Inventor: Kim, Bum Soo, Dalseo-gu Daegu Metropolitan City (KR); Lee, Moon Heui, Gumi-si,Gyeongsangbuk-do (KR); Kim, Yun Hyang, Gumi-si, yeongsanbuk-do (KR)
(74) Representative: Lang, Johannes

(57) **Abstract**

A mobile terminal device and method are provided for displaying remaining battery capacity. The device and method comprise internal and external batteries installed on the mobile terminal, a display unit displaying remaining battery capacity, a battery detecting unit identifying whether the external battery is additionally installed, a remaining battery capacity measuring unit measuring total recharged voltage of the internal and external batteries and a control unit displaying the total remaining battery capacity on the display unit corresponding to the measured total recharged voltage. Accordingly, a user may identify installation of the external battery more easily and avoid confusion due to rapid display changes in remaining battery capacity displayed as a recharged voltage difference between the internal and external batteries.

## Description

### BACKGROUND OF THE INVENTION

### Field of the Invention

The present invention relates generally to a mobile terminal device and method for displaying the remaining capacity of a battery. More particularly, the present invention relates to a mobile terminal device and method for enabling a user to identify the additional installation of an external battery more easily when remaining battery capacity is displayed.

### Description of the Prior Art

As a result of expanding human activity and related industry development, mobile communication means have been intensively developed to support users' convenience. After continuous development of mobile communication means, mobile terminals have become typical devices for mobile communication.

Generally, a mobile terminal is a terminal carried by an individual, such as a personal mobile communication services terminal, personal digital assistant (PDA), smart phone, International Mobile Telecommunication 2000 (IMT-2000), and wireless LAN terminal, that provides various functions for utilizing wireless communication and application programs.

Recently, mobile terminals appearing in the market have various application functions such as daily schedule management, games, and multimedia in addition to voice/image communication and short message transmission. Further, the mobile terminals may be provided with a camera function, and can take and save still and moving pictures like a digital camera.

With the introduction of the mobile terminal, users have come to utilize mobile telephone communication for calling whomever they want regardless of their location. Similarly, the mobile terminal utilizing wireless communication is a convenient device for communication and data transmission while moving.

The mobile terminal uses rechargeable batteries which store energy and supply electric power. The convenience of using a mobile terminal is in part determined by the remaining capacity of the rechargeable battery that is supplying the electric power. The user may manage operating time of the mobile terminal according to the remaining battery capacity.

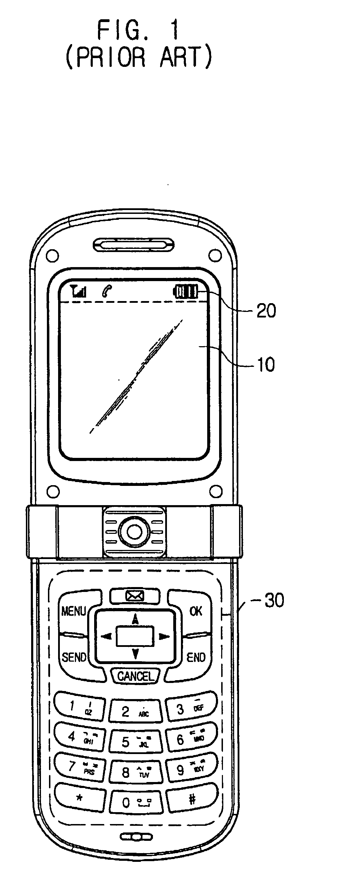

FIG. 1 is a view showing an example of displaying remaining battery capacity in a conventional mobile terminal.

As shown in FIG. 1, the mobile terminal includes an LCD display unit 10 displaying status information of the mobile terminal and a keypad 30 to input commands for operation of the mobile terminal.

At the upper part of the LCD display unit 10, remaining battery capacity is displayed as an icon 20 resembling a conventional battery (primary cell) in shape.

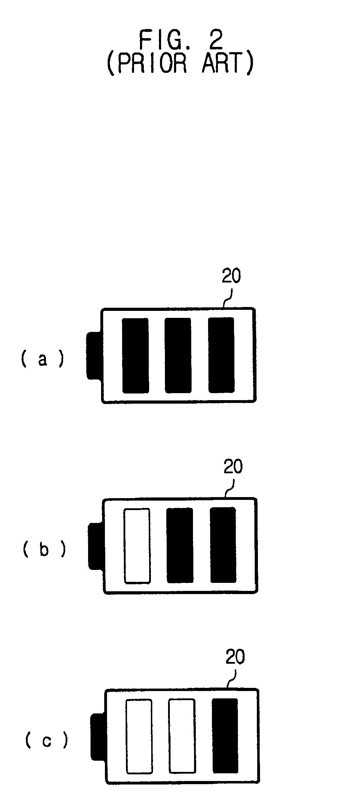

FIG. 2 is a view showing an example of displaying the remaining battery capacity of a battery installed on the mobile terminal.

As shown in FIG. 2, the remaining battery capacity 20 is displayed as a battery shape and configured with 3 blocks so that the remaining battery capacity can be identified.

FIG. 2(a) shows a remaining battery capacity of a fully recharged battery, in which all the 3 blocks of the icon 20 in a battery shape are filled with a predetermined color. FIG. 2(b) shows a remaining battery capacity of a battery having half of the full capacity remaining, in which 2 blocks out of the 3 blocks of the icon 20 are filled. FIG. 2(c) shows a remaining battery capacity of a battery having almost no power remaining, in which 1 block out of the 3 blocks of the icon 20 are filled.

Although the icon 20 in a battery shape displaying the remaining battery capacity has 3 blocks in FIG. 2, the icon 20 may have 4 or more blocks.

Mobile terminals capable of using an external battery have appeared in the market. Because the internal battery can only be used for a limited time, such mobile terminals have external batteries for the purpose of backing up the battery power to enable a longer communication time. By using the external battery, operating time of the mobile terminal may be extended. Accordingly, by installing the external battery on the mobile terminal when the internal battery of the mobile terminal is exhausted, the mobile terminal can be used longer. In this case, the remaining battery capacity of the mobile terminal is displayed as an average capacity of the internal and external batteries connected to each other in parallel.

However, in the case that an external battery not fully recharged is installed on a mobile terminal having a fully recharged internal battery, the user may be confused because the remaining battery capacity is displayed as a reduced voltage of the two batteries connected to each other in parallel.

In the conventional mobile terminal, a display method of remaining battery capacity simply displays an average capacity of the internal and external batteries without considering the additional installation of the external battery. This may make the mobile terminal user confused because display of the remaining battery capacity may be changed due to a voltage difference between the internal and external batteries.

For example, if an external battery having remaining battery capacity (20) of 1 block is additionally installed on a mobile terminal installed with an internal battery having remaining battery capacity (20) of 1 block, the total remaining battery capacity 20 is still displayed as 1 block. However, actual operating time may be doubled compared to the case that only the internal battery is installed. Therefore, the user may not recognize the actual capacity, and give up use of the terminal earlier by considering only the displayed remaining battery capacity.

Accordingly, there a need for an improved mobile terminal and method for displaying the remaining battery capacity.

### SUMMARY OF THE INVENTION

Exemplary embodiments of the present invention address at least the above problems and/or disadvantages and provide at least the advantages described below. Accordingly, an exemplary object of the present invention is to provide a mobile terminal and method for avoiding user confusion by displaying average recharged capacity as a remaining battery capacity of two batteries connected to each other in parallel when an external battery is additionally installed on the mobile terminal having an internal battery installed.

Another exemplary object of the present invention is to provide a mobile terminal and method for enabling a user to easily identify information on an additionally installed external battery when the external battery is installed on a mobile terminal which has an internal battery installed, differently from the case in which only the internal battery is installed, and a method thereof.

In order to achieve the above exemplary objects, a mobile terminal comprises internal and external batteries removeably installed on the mobile terminal, a display unit displaying remaining battery capacity information corresponding to voltage of the internal battery and external battery, a battery detecting unit determining whether the external battery is additionally installed on the mobile terminal in the state that the internal battery is installed, a remaining battery capacity measuring unit measuring the total voltage of the internal and external batteries, if the additional installation of the external battery is identified, and a control unit displaying total remaining battery capacity corresponding to the measured total voltage, instead of the displayed remaining battery capacity of the internal battery, on the display unit in a form different from the remaining battery capacity of the internal battery.

The external battery is connected to the internal battery in parallel, if the external battery is additionally installed.

The remaining battery capacity information may be displayed as a battery icon and at least a portion of an area of the battery icon may be configured with a plurality of internal blocks filled with a color according to the level of the voltage.

The control unit may display the total remaining battery capacity on the display unit by changing the color of the internal blocks of the battery icon that are displayed corresponding to the remaining battery capacity of the internal battery, if the external battery is additionally installed and the total recharged voltage of the two batteries is measured by the remaining battery capacity measuring unit.

In an alternative exemplary embodiment, the control unit may display the total remaining battery capacity on the display unit by enlarging the sizes of the battery icon and the internal blocks that are displayed corresponding to the remaining battery capacity of the internal battery, if the external battery is additionally installed and the total voltage of the two batteries is measured by the remaining battery capacity measuring unit.

In an alternative exemplary embodiment, the control unit may display the total remaining battery capacity on the display unit by dividing into a predetermined size the internal blocks of the battery icon that are displayed corresponding to the remaining battery capacity of the internal battery, if the external battery is additionally installed and the total voltage of the two batteries is measured by the remaining battery capacity measuring unit.

In an alternative exemplary embodiment, the control unit may display the total remaining battery capacity on the display unit by enlarging the size of the battery icon that is displayed corresponding to the remaining battery capacity of the internal battery and by filling the inner area of the enlarged battery icon with internal blocks having the same size as the previous internal blocks, if the external battery is additionally installed and the total recharged voltage of the two batteries is measured by the remaining battery capacity measuring unit.

In an exemplary embodiment, the battery icon may be configured with at least 3 internal blocks.

In an exemplary embodiment, at least the portion of the area of the battery icon is an inner area of the battery icon.

An exemplary method of displaying remaining battery capacity of a mobile terminal installed with internal and external batteries comprises displaying remaining battery capacity by measuring voltage of the installed internal battery, identifying installation of an external battery, measuring total voltage of the internal and external batteries, if installation of the external battery is identified, and displaying total remaining battery capacity corresponding to the measured total voltage, instead of the remaining battery capacity of the internal battery, on the display unit in a form different from the remaining battery capacity of the internal battery.

The remaining battery capacity may be displayed as a battery icon and at least a portion of an area of the battery icon may be configured with a plurality of blocks filled with a color according to the level of the voltage.

According to an exemplary embodiment of the present invention, in displaying the total remaining battery capacity, if the total voltage is measured in the measuring step, the total remaining battery capacity may be displayed by changing a color of the internal blocks of the battery icon that are displayed corresponding to the remaining battery capacity of the internal battery.

According to another exemplary embodiment of the present invention, in displaying the total remaining battery capacity, if the total voltage is measured in the measuring step, the total remaining battery capacity may be displayed by enlarging the sizes of the battery icon and the internal blocks that are displayed corresponding to the remaining battery capacity of the internal battery.

According to another exemplary embodiment of the present invention, in displaying the total remaining battery capacity, if the total voltage is measured in the measuring step, the total remaining battery capacity may be displayed by dividing into a size the internal blocks of the battery icon that are displayed corresponding to the remaining battery capacity of the internal battery.

According to another exemplary embodiment of the present invention, in displaying the total remaining battery capacity, if the total voltage is measured in the measuring step, the total remaining battery capacity may be displayed by enlarging the size of the battery icon that is displayed corresponding to the remaining battery capacity of the internal battery and by filling the inner area of the enlarged battery icon with internal blocks having the same size as the previous internal blocks.

According to another exemplary embodiment of the present invention, at least the portion of the area of the battery icon is an inner area of the battery icon.

According to the exemplary embodiments of the present invention, a user may identify installation of an external battery more easily by displaying remaining battery capacity according to the installation of the external battery in a form different from the remaining battery capacity in the state that only an internal battery is installed. Additionally, by displaying remaining battery capacity information according to the installation of an external battery in a form different from the remaining battery capacity in the state that only the internal battery is installed, the user may avoid confusion due to rapid display changes in remaining battery capacity displayed as a voltage difference between the internal battery and the external battery.

### BRIEF DESCRIPTION OF THE DRAWINGS

The above and other objects, features and advantages of the present invention will become more apparent from the following detailed description when taken in conjunction with the accompanying drawings, in which:
FIG. 1 is a view showing an example of displaying remaining battery capacity in a conventional mobile terminal;
FIG. 2 is a view showing an example of displaying remaining battery capacity of a battery installed on a mobile terminal;
FIG. 3 is a view showing a mobile terminal in a state in which an internal battery is installed thereon according to an exemplary embodiment of the present invention;
FIGS. 4A and 4B are views showing an external battery to be installed on a mobile terminal according to an exemplary embodiment of the present invention;
FIG. 5 is a block diagram of a mobile terminal easily detecting an external battery and displaying remaining battery capacity according to an exemplary embodiment of the present invention.
FIGs. 6a-h are views showing examples of display form of remaining battery capacity corresponding to additional installation of an external battery according to exemplary embodiments of the present invention; and
FIG. 7 is a flow chart of a display method of remaining battery capacity corresponding to additional installation of an external battery in a mobile terminal according to an exemplary embodiment of the present invention.

### DETAILED DESCRIPTION OF EXEMPLARY EMBODIMENTS

Hereinafter, exemplary embodiments of the present invention are described in detail with reference to the accompanying drawings. The same reference numbers are used for the same or like components in the accompanying drawings. Additionally, detailed explanations for well-known functions, constructions and compositions are omitted for clarity and conciseness.

Exemplary embodiments of the present invention disclose a mobile terminal and method for avoiding a user's confusion in the display of remaining battery capacity by displaying the remaining battery capacity in a different form when an external battery is additionally installed, compared to when only an internal battery is installed.

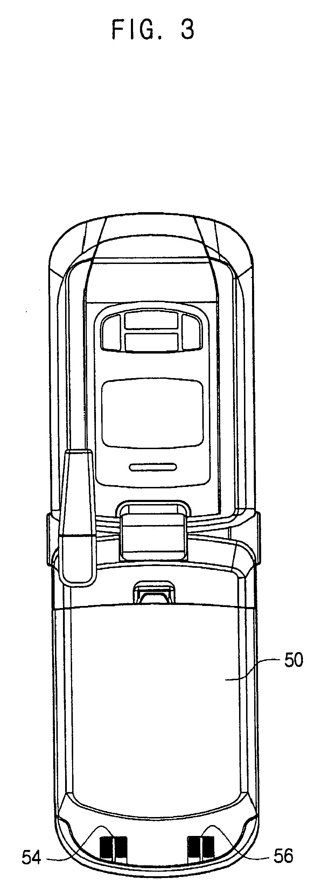

FIG. 3 is a view showing a mobile terminal in a state in which a battery is installed according to an exemplary embodiment of the present invention.

As shown in FIG. 3, an internal battery 50 of the mobile terminal is detachably installed at the rear side of the mobile terminal.

The internal battery 50 has recharging connectors 54 and 56 so that the battery 50 may be recharged by a charger (not shown) for the mobile terminal in the state that the battery 50 is attached to or detached from the mobile terminal.

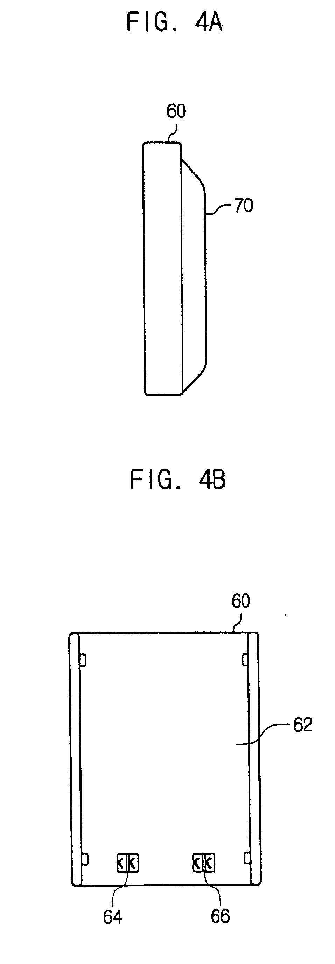

FIGS. 4A and 4B are views showing an external battery to be installed on a mobile terminal according to an exemplary embodiment of the present invention.

FIG. 4A is a side view of the external battery, and FIG. 4B is a view showing an installation surface of the external battery to be installed on the mobile terminal.

As shown in FIG. 4A, the external battery 70 is installed in a battery pack 60 formed to be easily installed on the mobile terminal. The external battery 70 is recharged by the charger in the state that the external battery 70 is attached to or detached from the battery pack 60.

As shown in FIG. 4B, installation connectors 64 and 66 are formed at an installation surface 62 of the battery pack 60. With this configuration, charging current may flow by connecting the installation connectors 64 and 66 respectively to the recharging connectors 56 and 54 of the internal battery 50 of FIG. 3, when the battery pack 60 is installed on the mobile terminal. That is, when the external battery 70 is additionally installed on the mobile terminal installed with the internal battery 50, the recharging connectors 56 and 54 are connected respectively to the installation connectors 64 and 66 in parallel. The mobile terminal displays an average remaining battery capacity of the internal battery 50 and the external battery 70 connected to each other in parallel as a remaining battery capacity. However, in exemplary embodiments of the present invention, differently from the case that only an internal battery is installed, installation status of the external battery is displayed in addition to the remaining battery capacity when the external battery is additionally installed.

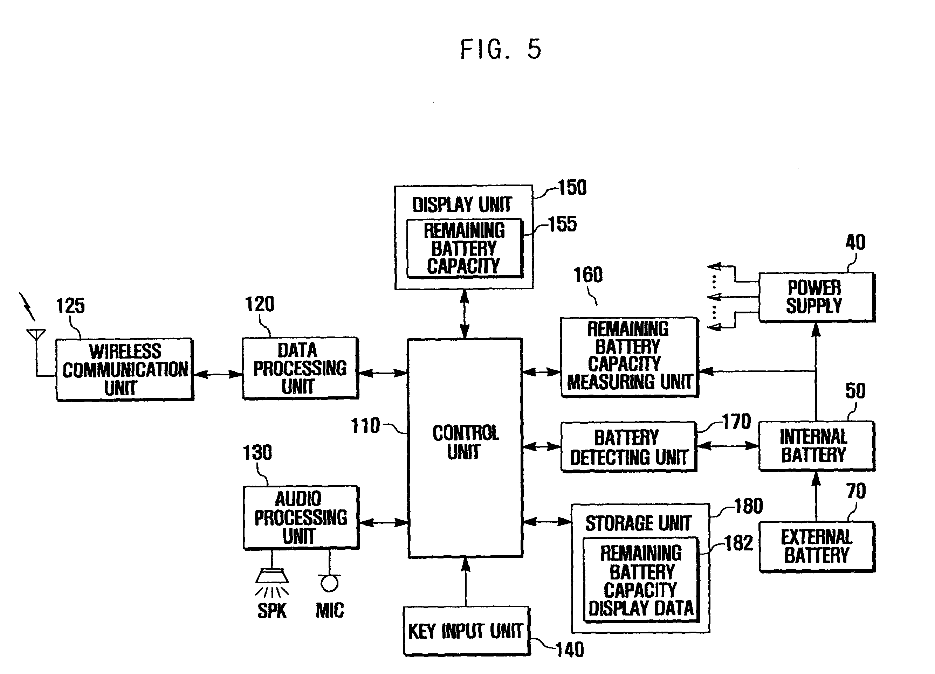

FIG. 5 is a block diagram of a mobile terminal easily detecting an external battery and displaying remaining battery capacity according to an exemplary embodiment of the present invention.

As shown in FIG. 5, the mobile terminal according to the exemplary embodiments of the present invention includes a control unit 110, data processing unit 120, wireless communication unit 125, audio processing unit 130, key input unit 140, display unit 150, remaining battery capacity measuring unit 160, battery detecting unit 170, and storage unit 180. The mobile terminal further includes a power supply 40, internal battery 50, and external battery 70 additionally installed to the internal battery 50.

The power supply 40 drops recharged voltage of the internal battery 50 and external battery 70 to a predetermined level, and supplies power to each module of the mobile terminal. The internal battery 50 and external battery 70 retain the voltage recharged by a charger, and supply electric power to the power supply 40 when the batteries are installed on the mobile terminal.

The control unit 110 performs a general operation control of the mobile terminal. When the external battery 70 is installed, the control unit 110 identifies the installation of the external battery 70, and measures and displays remaining battery capacity of the external battery 70 differently from the case that only the internal battery 50 is installed. When the external battery 70 is installed, the control unit 110 controls to display the remaining battery capacity in a different form compared to the case that only the internal battery 50 is installed.

The data processing unit 120 includes a transmission module encoding/modulating a signal for the transmission through a wireless channel, and a receiver module decoding/demodulating the signal received through the wireless channel. The data processing unit 120 decodes/demodulates received data, and transfers the data to the control unit 110. Additionally, the data processing unit 120 may encode/modulate data to be transmitted, and output to the wireless communication unit 125 according to the control of the control unit 110.

The wireless communication unit 125 performs a function of sending/receiving data for wireless communication of the mobile terminal. The wireless communication unit 125 may be configured with an RF transmitter upconverting and amplifying a signal to be transmitted and an RF receiver downconverting and low-noise amplifying the received signal. The wireless communication unit 125 receives data through a wireless channel and outputs to the data processing unit 120, and receives data output by the data processing unit 120 and transmits through the wireless channel.

The audio processing unit 130 may be configured with a CODEC (encoder/decoder) including a data CODEC processing packet data and an audio CODEC processing an audio signal such as a voice. In voice communication of the mobile terminal, the audio processing unit 130 converts a digital audio signal received by the data processing unit 120 to an analog signal through the audio CODEC, and outputs through a speaker. Additionally, the audio processing unit 130 may convert an analog audio signal input through a microphone to a digital audio signal through the audio CODEC, and transmit to the data processing unit 120 through the control unit 110.

The key input unit 140 includes a plurality of keys to input numbers and characters, and control keys to control the operation of the mobile terminal.

The display unit 150 displays the operation status of the mobile terminal and data output by the control unit 110. A liquid crystal display (LCD) may be used as the display unit 150. In this case, the display unit 150 includes an LCD control unit, memory storing image data, and LCD device. In the case that the LCD is provided with a touch screen, the display unit 150 may also be used as an input device.

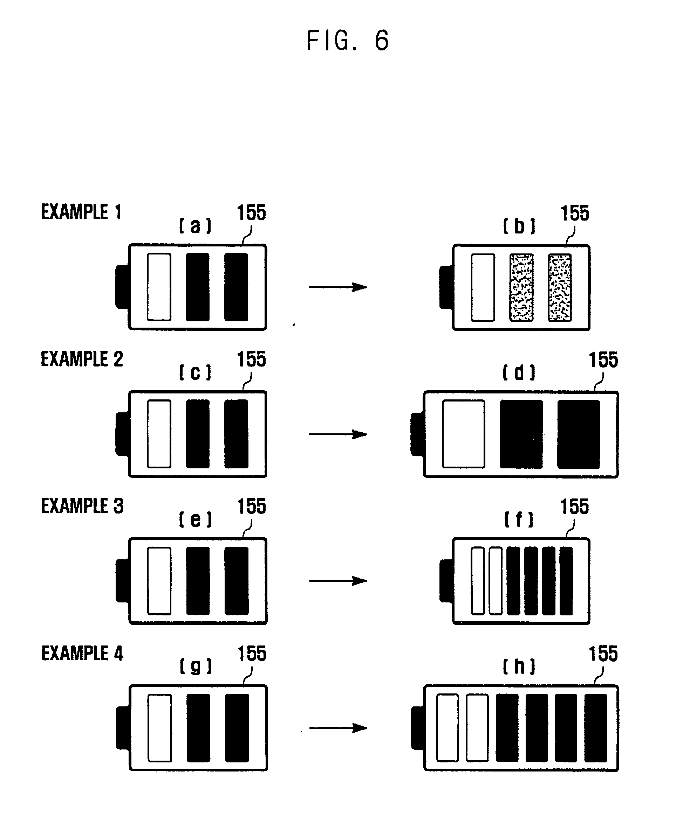

The display unit 150 displays the remaining battery capacity 155 according to the control of the control unit 110. When the display unit 150 displays the remaining battery capacity according to the control of the control unit 110, the display unit 150 displays the remaining battery capacity in different forms between the case that only the internal battery 50 is installed and the case that the external battery 70 is additionally installed. A detailed description for this follows later referring to FIG. 6.

When an internal battery 50 and/or an external battery 70 are installed on the mobile terminal, the remaining battery capacity measuring unit 160 measures recharged voltage of the installed batteries and transmits it to the control unit 110. When only the internal battery 50 is installed, the remaining battery capacity measuring unit 160 measures voltage of the internal battery 50, and transmits the voltage data to the control unit 110. When both internal battery 50 and external battery 70 are installed, the remaining battery capacity measuring unit 160 measures an average voltage of the two batteries 50 and 70 connected to each other in parallel, and transmits the voltage data to the control unit 110.

Accordingly, the control unit 110 displays the voltage measured by the remaining battery capacity measuring unit 160 as a remaining battery capacity on the display unit 150. When the external battery 70 is additionally installed, the control unit 110 displays the remaining battery capacity in a different form on the display unit 150.

The battery detecting unit 170 determines whether the external battery 70 is additionally installed on the mobile terminal installed with the internal battery 50, and transmits the result to the control unit 110. In an exemplary embodiment, the battery detecting unit 170 detects the external battery 70 by checking whether the installation connectors 64 and 66 are connected respectively to the recharging connectors 56 and 54. Accordingly, the control unit 110 displays the remaining battery capacity in a different form on the display unit 150 according to the installation information on the external battery 70 provided by the battery detecting unit 170.

The storage unit 180 stores programs executable by the mobile terminal and data generated by the programs. Additionally, the storage unit 180 may store remaining battery capacity display data 182 for displaying the remaining battery capacity in a different form on the display unit 150 according to the installation of the external battery 70.

According to the installation information on the external battery 70 provided by the battery detecting unit 170, the control unit 110 detects the remaining battery capacity in different forms referring to the remaining battery capacity display data 182 stored in the storage unit 180, and displays on the display unit 150.

A user may identify the installation status of the external battery 70 more easily, because the remaining battery capacity of the mobile terminal with the external battery 70 is displayed in a different form compared to that with only the internal battery 50 installed.

FIGs. 6a-h are views showing examples of display forms of remaining battery capacity corresponding to the additional installation of an external battery 70 according to exemplary embodiments of the present invention. The mobile terminal according to exemplary embodiments of the present invention may utilize any one among the display forms of the remaining battery capacity illustrated in FIGs. 6ah.

Examples where the external battery 70 is not installed are shown in (a), (c), (e), and (g) of FIG. 6, and examples where the external battery 70 is installed are shown in (b), (d), (f), and (h) of FIG. 6.

According to an exemplary embodiment of the present invention, if an external battery 70 is additionally installed, remaining battery capacity 155 may be displayed by changing the color of internal blocks of an icon as shown in FIG. 6(b). According to another exemplary embodiment of the present invention, if an external battery 70 is additionally installed, the remaining battery capacity 155 may be displayed differently by enlarging the sizes of the icon and internal blocks as shown in FIG. 6(d). According to another exemplary embodiment of the present invention, if an external battery 70 is additionally installed, the remaining battery capacity 155 may be displayed differently by reducing the size of the internal blocks as shown in FIG. 6(f). According to yet another exemplary embodiment of the present invention, if an external battery 70 is additionally installed, the remaining battery capacity 155 may be displayed differently by enlarging the size of the icon and maintaining the same size of the internal blocks as before as shown in FIG. 6(h).

The exemplary embodiments of the present invention may further include various display forms of the remaining battery capacity in addition to the above example embodiments, differently from a conventional display method. However, the variations or modifications may still fall within the spirit and scope of the present invention.

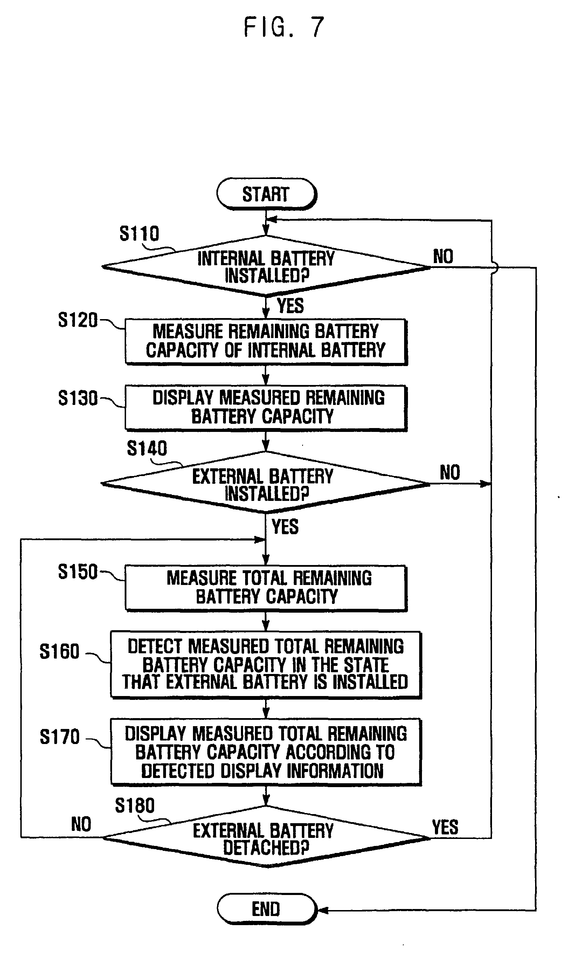

FIG. 7 is a flow chart of a display method of remaining battery capacity corresponding to additional installation of an external battery in a mobile terminal according to an exemplary embodiment of the present invention.

A battery detecting unit 170 detects the installation of an internal battery 50, and transmits the result to a control unit 110 in step S 110. If the installation of the internal battery is detected, the control unit 110 controls a remaining battery capacity measuring unit 160 to measure voltage of the installed internal battery 50 in step S120. Subsequently, the control unit 110 displays the remaining battery capacity on a display unit 150 corresponding to a voltage of the internal battery 50 measured by the remaining battery capacity measuring unit 160 in step S130.

The control unit 110 then controls the battery detecting unit 170 to identify the additional installation of an external battery 70 in step S140. If the additional installation of the external battery 70 is identified according to the result determined by the battery detecting unit 170, the control unit 110 controls the remaining battery capacity measuring unit 160 to measure a total voltage of the internal and external batteries 50 and 70 in step S 150. The remaining battery capacity measuring unit 160 measures the voltage of the internal and external batteries 50 and 70 connected to each other in parallel, and transmits the result to the control unit 110.

The control unit 110 searches remaining battery capacity display data 182 stored in a storage unit 180, and determines total remaining battery capacity display information measured in the state that the external battery 70 is installed in step S160. Subsequently, the control unit 110 displays the remaining battery capacity on the display unit 150 corresponding to the total voltage of the two batteries 50 and 70 measured, in the detected remaining battery capacity display method, by the remaining battery capacity measuring unit 160 in step S 170.

While displaying the remaining battery capacity in the state that the external battery 70 is additionally installed, the control unit 110 controls the battery detecting unit 170 to identify the detachment of the external battery 70 in step S180. If the detachment of the external battery 70 is not identified, step S 150 is repeated. If the detachment of the external battery 70 is identified, step S 110 is repeated.

According to exemplary embodiments of the present invention, a user may identify installation of an external battery more easily by displaying remaining battery capacity according to the installation of the external battery in a form different from the remaining battery capacity in the state that only an internal battery is installed.

Additionally, by displaying remaining battery capacity display information according to the installation of an external battery in a form different from the remaining battery capacity in the state that only the internal battery is installed, the user may avoid confusion due to rapid display changes in remaining battery capacity displayed as a voltage difference between the internal battery and the external battery.

Although exemplary embodiments of the present invention have been described in detail hereinabove, it should be understood that many variations and/or modifications of the basic inventive concept herein described, which may appear to those skilled in the art, will still fall within the spirit and scope of the exemplary embodiments of the present invention as defined in the appended claims and the full scope of equivalents thereof.

## Claims

1. A mobile terminal comprising:
a display unit for displaying remaining battery capacity information;
a battery detecting unit for determining whether an external battery is installed on the mobile terminal in a state in which an internal battery is installed on the mobile terminal;
a remaining battery capacity measuring unit for measuring total voltage of the internal battery and the external battery if the installation of the external battery is detected; and
a control unit for controlling display of total remaining battery capacity corresponding to the measured total voltage on the display unit differently from the remaining battery capacity corresponding to voltage of the internal battery.

2. The mobile terminal of claim 1, wherein the external battery is connected to the internal battery in parallel, if the external battery is additionally installed.

3. The mobile terminal of claim 2, wherein the display unit comprises a battery icon for displaying battery capacity information, and at least a portion of an area of the battery icon comprises a plurality of internal blocks filled with a color according to a level of the measured voltage.

4. The mobile terminal of claim 3, wherein the control unit controls display of the total remaining battery capacity on the display unit by changing a color of the internal blocks of the battery icon that are displayed corresponding to the remaining battery capacity of the internal battery, if the external battery is installed and the total voltage of the two batteries is measured by the remaining battery capacity measuring unit.

5. The mobile terminal of claim 3, wherein the control unit controls display of the total remaining battery capacity on the display unit by enlarging a size of the battery icon and the internal blocks that are displayed corresponding to the remaining battery capacity of the internal battery, if the external battery is installed and the total voltage of the two batteries is measured by the remaining battery capacity measuring unit.

6. The mobile terminal of claim 3, wherein the control unit controls display of the total remaining battery capacity on the display unit by dividing the internal blocks of the battery icon into areas that are displayed corresponding to the remaining battery capacity of the internal battery, if the external battery is installed and the total voltage of the two batteries is measured by the remaining battery capacity measuring unit.

7. The mobile terminal of claim 3, wherein the control unit controls display of the total remaining battery capacity on the display unit by enlarging a size of the battery icon that is displayed corresponding to the remaining battery capacity of the internal battery and by filling the at least the portion of the area of the enlarged battery icon with internal blocks having the same size as the previous internal blocks, if the external battery is installed and the total voltage of the two batteries is measured by the remaining battery capacity measuring unit.

8. The mobile terminal of claim 3, wherein the battery icon comprises 3 or more internal blocks.

9. A method of displaying remaining battery capacity of a mobile terminal, the method comprising:
displaying remaining battery capacity by measuring voltage of an installed internal battery;
determining installation of an external battery;
measuring total voltage of the internal and external batteries, if the installation of the external battery is determined; and
displaying total remaining battery capacity corresponding to the measured total voltage on the display unit differently from the remaining battery capacity of the internal battery.

10. The method of claim 9, wherein installation of the external battery comprises a parallel connection to the internal battery.

11. The method of claim 10, wherein displaying the remaining battery capacity information comprises displaying a battery icon wherein at least a portion of an area of the battery icon comprises a plurality of blocks filled with a color according to the level of the measured voltage.

12. The method of claim 11, wherein displaying the total remaining battery capacity comprises changing the color of the internal blocks of the battery icon that are displayed corresponding to the remaining battery capacity of the internal battery, if the total recharged voltage is measured in the measuring step.

13. The method of claim 11, wherein displaying the total remaining battery capacity comprises enlarging a size of the battery icon and the internal blocks that are displayed corresponding to the remaining battery capacity of the internal battery, if the total recharged voltage is measured in the measuring step.

14. The method of claim 11, wherein displaying the total remaining battery capacity comprises dividing the internal blocks of the battery icon into areas that are displayed corresponding to the remaining battery capacity of the internal battery, if the total recharged voltage is measured in the measuring step.

15. The method of claim 11, wherein displaying the total remaining battery capacity comprises enlarging the size of the battery icon that is displayed corresponding to the remaining battery capacity of the internal battery and filling the at least the portion of the area of the enlarged battery icon with internal blocks having the same size as the previous internal blocks, if the total recharged voltage is measured in the measuring step.

16. The mobile terminal of claim 3, wherein the at least the portion of the area of the battery icon is an inner area of the battery icon.

17. The method of claim 11, wherein the at least the portion of the area of the battery icon is an inner area of the battery icon.
